Europäisches Patentamt

European Patent Office

Office européen des brevets

(19)

(11) EP 0 421 395 B2

(12) **NEUE EUROPÄISCHE PATENTSCHRIFT**

(45) Veröffentlichungstag und Bekanntmachung des Hinweises auf die Entscheidung über den Einspruch:
**11.11.1998 Patentblatt 1998/46**

(51) Int Cl.⁶: **H03M 1/82**

(45) Hinweis auf die Patenterteilung:
**20.12.1995 Patentblatt 1995/51**

(21) Anmeldenummer: **90118995.1**

(22) Anmeldetag: **04.10.1990**

(54) **Anordnung zur Umwandlung einer elektrischen Eingangsgrösse in ein dazu proportionales elektrisches Gleichsignal**

Arrangement for the conversion of an electrical input value to a direct electrical signal proportional thereto

Agencement de conversion d'une grandeur électrique d'entrée en un signal électrique continu proportionnel à ladite grandeur

(84) Benannte Vertragsstaaten:
**CH DE FR GB IT LI**

(30) Priorität: **06.10.1989 DE 3933491**

(43) Veröffentlichungstag der Anmeldung:
**10.04.1991 Patentblatt 1991/15**

(73) Patentinhaber: **Endress u. Hauser GmbH u. Co.
D-79689 Maulburg (DE)**

(72) Erfinder:
• **Elle, André
W-7851 Rümmingen (DE)**
• **Lange, Günter
W-7730 Villingen (DE)**

(74) Vertreter: **Leiser, Gottfried, Dipl.-Ing. et al
Prinz & Partner GbR
Manzingerweg 7
81241 München (DE)**

(56) Entgegenhaltungen:
EP-A- 280 321        GB-A- 2 144 005
US-A- 3 823 396      US-A- 4 058 772
US-A- 4 087 813      US-A- 4 685 114

EP 0 421 395 B2

**Beschreibung**

Die Erfindung betrifft eine Anordnung zur Umwandlung einer elektrischen Eingangsgröße in ein dazu proportionales elektrisches Gleichsignal, mit einem ersten digitalen Pulsdauermodulatur begrenzter Auflösung, der eine erste periodische Impulsfolge liefert, die mit dem der begrenzten Auflösung entsprechenden Quantisierungswert der Eingangsgröße unter Vernachlässigung des Quantisierungsrestes pulsdauermoduliert ist, einem zweiten Pulsdauermodulatur begrenzter Auflösung, der eine zweite periodische Impulsfolge liefert, die in Abhängigkeit vom Quantisierungsrest pulsdauermoduliert ist, und mit einer Mittelungsschaltung zur Bildung eines Gleichsignalmittelwerts aus den pulsdauermodulierten Impulsfolgen.

Eine solche Anordnung ist z. B. bekannt aus der US-A-3 823 396. Bei der Umwandlung einer elektrischen Eingangsgröße in ein dazu proportionales elektrisches Gleichsignal durch Bildung des Gleichsignalmittelwerts von mit dem Wert der Eingangsgröße pulsdauermodulierten Impulsen ist die Genauigkeit der Umwandlung durch das Auflösungsvermögen des digitalen Pulsdauermodulators beschränkt. Wenn beispielsweise ein handelsüblicher 8 Bit-Pulsdauermodulator verwendet wird, kann der gesamte Wertebereich der Eingangsgröße nur in $2^8 = 256$ Quantisierungswerte umgesetzt werden, und dementsprechend kann das Gleichsignal nur jeweils einen der dazu proportionalen 256 Werte annehmen. Durch die aus der US-A-3 823 396 bekannte Aufteilung der Eingangsgröße in einen der begrenzten Auflösung entsprechenden Quantisierungswert, der bei digitaler Darstellung der Eingangsgröße den höherwertigen Bits entspricht, und einen Quantisierungsrest, der den durch die begrenzte Auflösung nicht mehr erfaßten niederwertigen Bits entspricht, kann mit Hilfe von zwei Pulsdauermodulatoren begrenzter Auflösung eine erhöhte Genauigkeit erzielt werden, die derjenigen entspricht, die mit einem Pulsdauermodulator von wesentlich höherer Auflösung erzielt wird.

Es besteht jedoch das Problem, daß die Gleichsignalmittelwerte der beiden pulsdauermodulierten Impulsfolgen nicht einfach addiert werden können, um das der elektrischen Eingangsgröße proportionale elektrische Gleichsignal zu erhalten, denn dann wäre der Quantisierungsrest in dem Summensignal übergewichtet. Diese Übergewichtung muß daher bei der Bildung des der gesamten Eingangsgröße proportionalen Gleichsignals ausgeglichen werden. Bei der aus der US-A-3 823 396 bekannten Anordnung wird der Gleichsignalmittelwert jeder der beiden pulsdauermodulierten Impulsfolgen durch Integration mittels eines RC-Gliedes gebildet, wobei die beiden RC-Glieder getrennte Widerstände, aber einen gemeinsamen Kondensator aufweisen. Die getrennten Widerstände haben unterschiedliche Werte, die in Verbindung mit der Kapazität des gemeinsamen Kondensators unterschiedliche Zeitkonstanten ergeben, durch die die Übergewichtung des Quantisierungsrestes in der zweiten Impulsfolge ausgeglichen wird, und die Summe der beiden mit unterschiedlicher Gewichtung erhaltenen Gleichsignalmittelwerte bildet sich unmittelbar auf dem gemeinsamen Kondensator.

Bei dieser Summenbildung von Gleichsignalmittelwerten unter Ausgleich der Übergewichtung des dem Quantisierungsrest entsprechenden Gleichsignalmittelwerts auf rein analoge Weise mit Hilfe von unterschiedlich bemessenen Widerständen bestehen wieder die üblichen Probleme analoger Signalverarbeitung, die eigentlich durch den Umweg über die Pulsdauermodulation beseitigt werden sollen. Insbesondere bestehen hohe Anforderungen an die Genauigkeit des Verhältnisses der beiden Integrationswiderstände, denn da der Quantisierungsrest im Verhältnis zum Quantisierungswert sehr klein ist, kann schon eine kleine Abweichung vom richtigen Verhältnis einen Fehler verursachen, der die durch die zweifache Pulsdauermodulation angestrebte Verbesserung wieder aufhebt. Ferner müssen die bei analoger Signalverarbeitung erforderlichen Maßnahmen getroffen werden, um das genaue Widerstandsverhältnis auch bei sich ändernden Betriebsbedingungen, insbesondere bei Temperaturänderungen, aufrecht zu erhalten.

In der EP-A-0 280 321 ist eine Anordnung zur Umwandlung einer digitalen elektrischen Größe in ein dazu proportionales Gleichsignal beschrieben, bei der die durch m + n Bits dargestellte digitale Eingangsgröße gleichfalls in einen einer begrenzten Auflösung entsprechenden, aus den m höherwertigen Bits bestehenden Quantisierungswert und einen aus den n niederwertigen Bits bestehenden Quantisierungsrest aufgeteilt ist. Bei dieser bekannten Anordnung wird jedoch keine Pulsdauermodulation angewendet, sondern Quantisierungswert und Quantisierungsrest werden zwei getrennten Digital-Analog-Umsetzern zugeführt, die in herkömmlicher Weise mit Widerstandsnetzen ausgebildet sind. Der eine Digital-Analog-Umsetzer liefert einen Gleichstrom, der dem Quantisierungswert entspricht, und der andere Digital-Analog-Umsetzer liefert einen Gleichstrom, der dem mit dem Faktor $2^n$ multiplizierten Quantisierungsrest entspricht. Die beiden Gleichströme werden durch einen Analogaddierer summiert, der so gewichtet ist, daß die Übergewichtung des Quantisierungsrestes ausgeglichen wird. Zur Behebung des durch die Digital-Analog-Umsetzung des Quantisierungswertes verursachten Genauigkeitsfehlers wird zu dem Quantisierungsrest vor dessen Digital-Analog-Umsetzung ein Korrekturwert addiert, der vom Quantisierungswert abhängt. Die verschiedenen Korrekturwerte sind beispielsweise in einem Festwertspeicher gespeichert, aus dem sie unter Adressierung durch den Quantisierungswert ausgelesen werden.

Aufgabe der Erfindung ist die Schaffung einer Anordnung der eingangs angegebenen Art, bei der die durch eine analoge Signalverarbeitung entstehenden Schwierigkeiten vermieden sind.

Nach der Erfindung wird diese Aufgabe dadurch gelöst, daß die von dem zweiten Pulsdauermodulator gelieferte zweite periodische Impulsfolge mit der Summe aus dem der begrenzten Auflösung entsprechenden Quantisierungswert und dem mit einem vorbestimmten Faktor multiplizierten Quantisierungsrest pulsdauermoduliert ist, und daß eine Umschaltanordnung vorgesehen ist, die die Impulse der beiden Impulsfolgen derart abwechselnd zur Mittelungsschaltung durchschaltet, daß das Verhältnis der durchgeschalteten Impulse der zweiten Impulsfolge zur Gesamtzahl der durchgeschalteten Impulse gleich dem Kehrwert des vorbestimmten Faktors ist.

Gemäß der Erfindung erfolgt die Summenbildung unter Ausgleich der Übergewichtung des Quantisierungsrestes durch Abzählen und abwechselndes Durchschalten von Impulsen, also mit rein digitalen Mitteln. Das Ergebnis ist eine neue Impulsfolge, deren Gleichsignalmittelwert der gesamten elektrischen Eingangsgröße einschließlich des Quantisierungsrestes proportional ist. Aus der neuen Impulsfolge kann durch die Mittelungsschaltung in gleicher Weise wie bei einer von einem einzigen Pulsdauermodulator gelieferten Impulsfolge der Gleichsignalmittelwert gebildet werden, ohne daß hierbei eine unterschiedliche Gewichtung durch Widerstände oder andere analoge Mittel erfolgen muß.

Ein Ausführungsbeispiel der Erfindung wird nachfolgend an Hand der Zeichnung beschrieben. In der Zeichnung zeigen:

Fig. 1    das Prinzipschema der bei der Erfindung angewendeten Umwandlung einer Eingangsgröße in ein dazu proportionales Gleichsignal durch digitale Pulsdauermodulation,

Fig. 2    das Blockschaltbild einer Ausführungsform der erfindungsgemäßen Anordnung und

Fig. 3    Diagramme von Signalen, die in der Anordnuna von Fig. 2 auftreten.

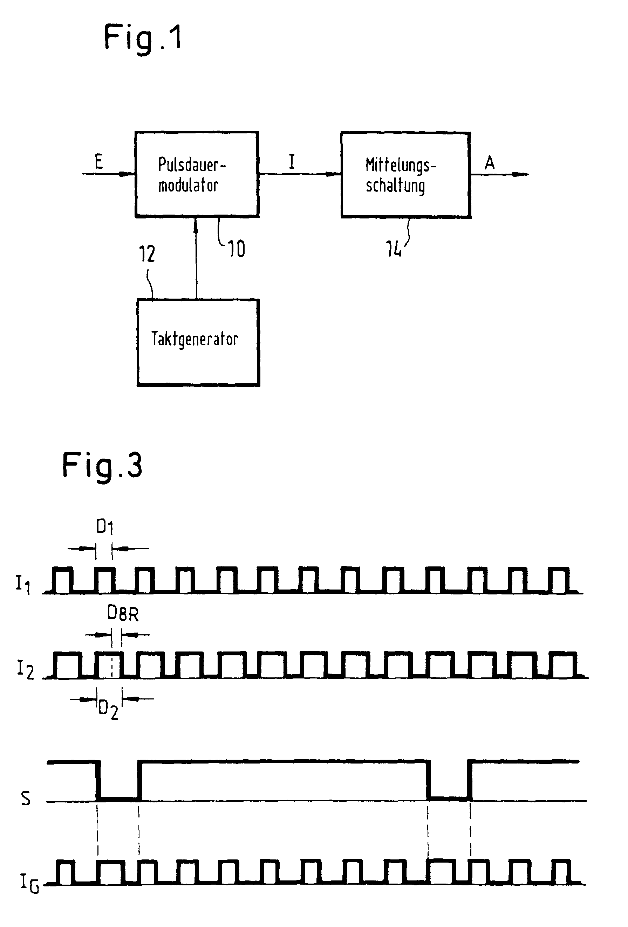

Fig. 1 zeigt schematisch das bei der Erfindung angewendete bekannte Prinzip der Umwandlung einer elektrischen Eingangsgröße E in ein analoges Ausgangssignal A, das durch ein zur Eingangsgröße proportionales elektrisches Gleichsignal gebildet ist. Unter einem "Gleichsignal" ist hier ein Gleichstrom oder eine Gleichspannung zu verstehen. Die Eingangsgröße E wird als Modulationssignal einem Pulsdauermodulator 10 zugeführt, der am Ausgang eine Impulsfolge I abgibt, deren Impulse mit konstanter Periode aufeinanderfolgen und eine Dauer haben, die dem Wert der Eingangsgröße E proportional ist. Demzufolge ist auch das Tastverhältnis der Impulse, also das Verhältnis der Impulsdauer zur Periodendauer, dem Wert der Eingangsgröße E proportional. Die Folgefrequenz der Impulsfolge I ist beispielsweise durch ein von einem Taktgenerator 12 geliefertes Taktsignal bestimmt. Die pulsdauermodulierte Impulsfolge 1 wird einer Mittelungsschaltung 14 zugeführt, die am Ausgang ein Signal abgibt, das dem Gleichsignalmittelwert, also dem Gleichstrommittelwert oder dem Gleichspannungsmittelwert der pulsdauermodulierten Impulse entspricht. Die Mittelungsschaltung 14 kann beispielsweise durch ein Tiefpaßfilter gebildet sein. Der von der Mittelungsschaltung 14 erhaltene Gleichsignalmittelwert ist dem Tastverhältnis der pulsdauermodulierten Impulsfolge I proportional, und da dieses Tastverhältnis dem Wert der Eingangsgröße E proportional ist, ist auch der Gleichsignalmittelwert dem Wert der Eingangsgröße E proportional. Der Gleichsignalmittelwert stellt also das gewünschte Ausgangssignal A dar.

Die Genauigkeit, mit der die Eingangsgröße E in das dazu proportionale Gleichsignal A umgewandelt wird, hängt von dem Auflösungsvermögen des Pulsdauermodulators 10 ab. Wenn hierfür beispielsweise ein handelsüblicher digitaler Pulsdauermodulator mit der verhältnismäßig geringen Auflösung von 8 Bit verwendet wird, kann sich die Impulsdauer der pulsdauermodulierten Impulsfolge I über die ganze Impulsperiode nur in $2^8 = 256$ Stufen ändern, und demzufolge kann der Gleichsignalmittelwert nur 256 verschiedene Werte annehmen. Die Zwischenwerte der Eingangsgröße E werden durch die jeweils nächstniedrigere Stufe des Ausgangssignals A wiedergegeben. Die dadurch erzielte Umwandlungsgenauigkeit ist für viele Anwendungszwecke unzureichend.

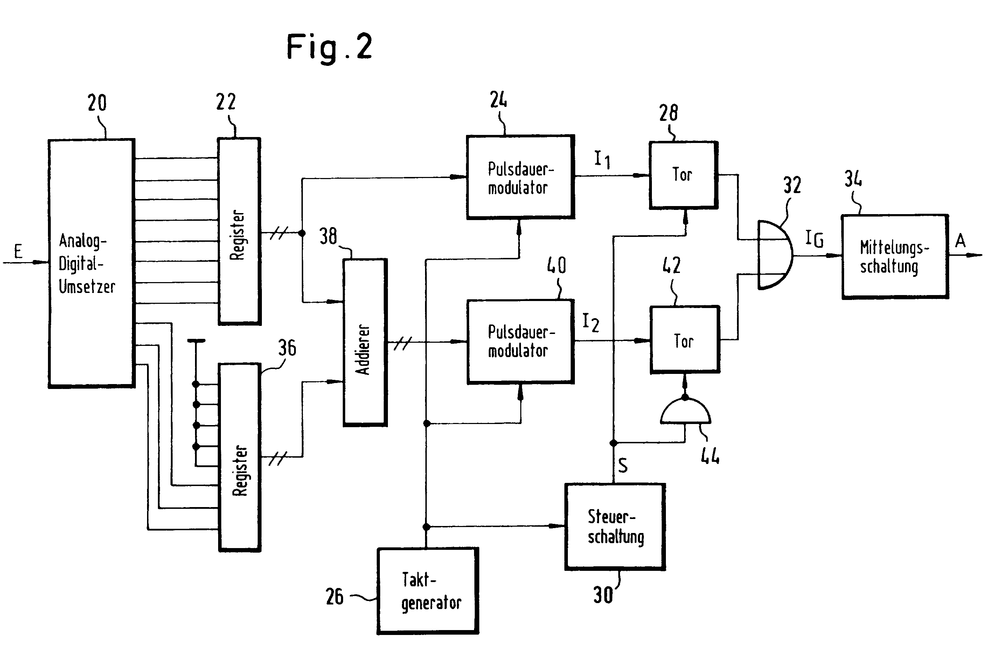

Fig. 2 zeigt eine Umwandlungsschaltung, die unter Beibehaltung des Prinzips einer mit begrenzter Auflösung durchgeführten Pulsdauermodulation eine Umwandlung mit wesentlich höherer Genauigkeit ergibt.

In Fig. 2 ist angenommen, daß es sich bei der Eingangsgröße E um eine analoge Größe handelt. Die analoge Eingangsgröße E wird einem Analog-Digital-Umsetzer 20 mit der verhältnismäßig hohen Auflösung von 11 Bit zugeführt. Der Analog-Digital-Umsetzer 20 kann den gesamten Wertebereich der analogen Eingangsgröße E in $2^{11} = 2048$ Werte umsetzen, die jeweils einer Quantisierungsstufe der analogen Eingangsgröße E entsprechen. Der Analog-Digital-Umsetzer 20 gibt an elf Ausgängen eine elfstellige binäre Codegruppe aus, die den quantisierten Wert der analogen Eingangsgröße als Dualzahl wiedergibt. In der Zeichnung ist der unterste Ausgang des Analog-Digital-Umsetzers 20 der Dualstelle mit dem niedrigsten Stellenwert und der oberste Ausgang der Dualstelle mit dem höchsten Stellenwert zugeordnet.

Die acht Ausgänge der höchsten Stellenwerte sind mit den Eingängen eines achtstufigen Registers 22 verbunden, in das somit eine binäre Codegruppe eingegeben wird, die aus den acht Binärziffern des höchsten Stellenwerts der vom Analog-Digital-Umsetzer 20 gelieferten binären Codegruppe besteht. Die im Register 22 stehende binäre Codegruppe bildet eine achtstellige Dualzahl, deren Zahlenwert dem durch $2^3 = 8$ dividierten Zahlenwert der vom Analog-Digital-Umsetzer 20 gelieferten elfstelligen Dualzahl unter Vernachlässigung des Divisionsrestes erhalten wird. Wenn beispielsweise die vom Analog-Digital-Umsetzer 20 gelieferte elfstellige Dualzahl den dezimalen Zahlenwert 717 hat, entspricht der dezimale Zahlenwert der im Register 22 stehenden achtstelligen Dualzahl dem ganzzahligen Teil des Quotienten der Division

$$717:8 = 89,625,$$

also dem dezimalen Zahlenwert 89 unter Vernachlässigung des Divisionsrestes 0,625. Dies ergibt sich unmittelbar aus der folgenden Gegenüberstellung der entsprechenden Dualzahlen:

```
A/D-Umsetzer 20:   0 1 0 1 1 0 0 1 1 0 1 = 717
Register 22:       0 1 0 1 1 0 0 1        =  89
```

Der nicht berücksichtigte Divisionsrest ergibt sich aus den Binärziffern an den drei den niedrigsten Stellenwerten zugeordneten Ausgängen des Analog-Digital-Umsetzers 20, die nicht mit dem Register 22 verbunden sind.

Im Register 22 kann also der gesamte Wertebereich der analogen Eingangsgröße E nur durch $2^8 = 256$ digitale Werte wiedergegeben werden, die jeweils einem Quantisierungswert mit der begrenzten Auflösung von 8 Bit entsprechen, und der jeweils im Register 22 stehende digitale Zahlenwert entspricht einem dieser 256 Quantisierungswerte unter Vernachlässigung des Quantisierungsrestes.

Die Ausgänge des Registers 22 sind mit den Modulationssignaleingängen eines digitalen Pulsdauermodulators 24 verbunden, der die gleiche Auflösung von 8 Bit wie das Register 22 hat. Der Pulsdauermodulator 24 entspricht dem Pulsdauermodulator 10 von Fig. 1 und gibt am Ausgang eine pulsdauermodulierte Impulsfolge $I_1$ ab, deren Impulsperiode durch ein von einem Taktgenerator 26 geliefertes Taktsignal bestimmt ist und deren Impulse eine Dauer haben, die dem im Register 22 stehenden digitalen Zahlenwert proportional ist. Der Ausgang des Pulsdauermodulators 24 ist mit dem Signaleingang einer Torschaltung 28 verbunden, deren Steuereingang mit dem Ausgang einer durch den Taktgenerator 26 synchronisierten Steuerschaltung 30 verbunden ist, so daß die Torschaltung 28 durch ein von der Steuerschaltung 30 geliefertes Steuersignal S geöffnet oder geschlossen wird. Der Ausgang der Torschaltung 28 ist über eine Oder-Schaltung 32 mit einer Mittelungsschaltung 34 verbunden, die der Mittelungsschaltung 14 von Fig. 1 entspricht und beispielsweise durch ein Tiefpaßfilter gebildet sein kann. Wenn die Torschaltung 28 von der Steuerschaltung 30 geöffnet ist, wird somit die pulsdauermodulierte Impulsfolge $I_1$ zu der Mittelungsschaltung 34 übertragen. Die bisher beschriebenen Bestandteile der Schaltung von Fig. 2 arbeiten dann in der gleichen Weise wie die zuvor beschriebene Schaltung von Fig. 1.

Die übrigen Bestandteile der Schaltung von Fig. 2 dienen der Erhöhung der Genauigkeit, mit der die analoge Eingangsgröße E in das am Ausgang abgegebene Gleichsignal A umgewandelt wird. Zu diesem Zweck ist ein zweites achtstufiges Register 36 vorgesehen, dessen drei dem niedrigsten Stellenwert zugeordnete Eingänge mit den drei dem niedrigsten Stellenwert zugeordneten Ausgängen des Analog-Digital-Umsetzers 20 verbunden sind, während die übrigen Eingänge des Registers 36 nicht beschaltet sind. Im Register 36 steht daher eine achtstellige Dualzahl, deren fünf erste Stellen den Wert "0" haben und in deren drei letzten Stellen die Binärziffern der drei letzten Stellen der elfstelligen Dualzahl stehen, die vom Analog-Digital-Umsetzer 20 ausgegeben wird.

Die Ausgänge des Registers 36 sind mit einer zugeordneten Gruppe von Eingängen eines Addierers 38 verbunden, dessen zweite Eingangsgruppe mit den Ausgängen des Registers 22 verbunden ist. Der Addierer 38 bildet die Summe der beiden achtstelligen Dualzahlen, die in den Registern 22 und 36 stehen, und gibt eine dieser Summe entsprechende achtstellige Dualzahl an seinen Ausgängen ab.

Die Ausgänge des Addierers 38 sind mit den Modulationssignaleingängen eines digitalen Pulsdauermodulators 40 verbunden, der von gleicher Art wie der Pulsdauermodulator 24 ist, also die gleiche begrenzte Auflösung von 8 Bit hat. Der Pulsdauermodulator 40 empfängt ebenfalls das vom Taktgenerator 26 gelieferte Taktsignal und gibt am Ausgang eine pulsdauermodulierte Impulsfolge $I_2$ ab, deren Impulse die gleiche, durch den Taktgenerator 26 bestimmte konstante Periode wie die Impulse der Impulsfolge $I_1$ haben und deren Dauer dem Zahlenwert der vom Addierer 38 abgegebenen Dualzahl proportional ist. Der Ausgang des Pulsdauermodulators 40 ist mit dem Signaleingang einer Torschaltung 42 verbunden, die an ihrem Steuereingang das von der Steuerschaltung 30 gelieferte Steuersignal S über einen Invertierer 44 empfängt so daß die Torschaltung 42 gegensinnig zu der Torschaltung 28 geöffnet und geschlossen wird. Der Ausgang der Torschaltung 42 ist über die Oder-Schaltung 32 mit der Mittelungsschaltung 34 verbunden.

Bei der Addition im Addierer 38 werden die Binärziffern der drei letzten Stellen der im Register 36 stehenden Dualzahl stellengleich zu den Binärziffern der drei letzten Stellen der im Register 22 stehenden Dualzahl addiert. Bei dem zuvor angegebenen Zahlenbeispiel erfolgt also die Addition nach dem folgenden Schema:

```
Register 22:   0 1 0 1 1 0 0 1   =   89
Register 36:   0 0 0 0 0 1 0 1   =    5
Addierer 38:   0 1 0 1 1 1 1 0   =   94
```

Die drei letzten Stellen der im Register 36 stehenden Dualzahl sind also für die Addition um drei Stellen in Richtung höherer Stellenwerte verschoben worden, was einer Multiplikation mit dem Faktor $2^3 = 8$ entspricht. Diese drei Stellen entsprechen dem Divisionsrest, der bei der Pulsdauermodulation im Pulsdauermodulator 24 nicht berücksichtigt worden ist. Bei dem obigen Zahlenbeispiel hat der Divisionsrest den Dezimalwert 0,625; er geht nun in die Addition mit dem Dezimalwert $0{,}625 \cdot 8 = 5$ ein.

Bezogen auf den Wert der anlogen Eingangsgröße E entspricht die im Register 22 stehende Dualzahl, wie zuvor erläutert wurde, einem Quantisierungswert der Eingangsgröße E mit der auf 8 Bit begrenzten Auflösung, wobei der Quantisierungsrest unberücksichtigt bleibt. Der Quantisierungsrest ist nur dann Null, wenn der Wert der Eingangsgröße E zufällig genau dem Quantisierungswert entspricht. Wenn der Quantisierungsrest von Null verschieden ist, ist die Impulsdauer der pulsdauermodulierten Impulsfolge $I_1$ um einen dem Quantisierungsrest proportionalen Betrag kleiner als die Impulsdauer, die dem genauen Wert der Eingangsgröße E entsprechen würde.

Demgegenüber entspricht die vom Addierer 38 abgegebene Dualzahl der Summe aus dem im Pulsdauermodulator 24 berücksichtigten Quantisierungswert und aus dem mit dem Faktor 8 multiplizierten Quantisierungsrest, wobei auch diese Summe mit einer Auflösung von 8 Bit dargestellt ist. Wenn der Quantisierungsrest von Null verschieden ist, ist also die Impulsdauer der pulsdauermodulierten Impulsfolge $I_2$ um das 7-fache des Quantisierungsrestes größer als die Impulsdauer, die dem genauen Wert der Eingangsgröße E entsprechen würde.

Zum besseren Verständnis der Funktionsweise sind die Impulsfolgen $I_1$ und $I_2$ in den mit den gleichen Bezeichnungen versehenen Diagrammen von Fig. 3 dargestellt. Weitere Diagramme von Fig. 3 zeigen den zeitlichen Verlauf des von der Steuerschaltung 30 gelieferten Steuersignals S und die am Ausgang der Oder-Schaltung 32 erhaltene Gesamtimpulsfolge $I_G$.

Wenn das Steuersignal S den hohen Signalpegel hat, ist die Torschaltung 28 geöffnet und die Torschaltung 42 geschlossen. Wenn das Steuersignal S den niedrigen Signalpegel hat, ist die Torschaltung 42 geöffnet und die Torschaltung 28 geschlossen.

Die Steuerscbaltung 30 ist so ausgebildet, daß das Steuersignal S jeweils für sieben aufeinanderfolgende Impulsperioden der Impulsfolgen $I_1$ und $I_2$ den hohen Signalpegel und dann für eine Impulsperiode den niedrigen Signalpegel hat. Die zur Mittelungsschaltung 34 übertragene Gesamtimpulsfolge $I_G$ enthält also in jeweils acht aufeinanderfolgenden Impulsen sieben Impulse der Impulsfolge $I_1$ und einen Impuls der Impulsfolge $I_2$.

Da die Impulsdauer D2 der Impulse der Impulsfolge 12 gleich der Summe aus der Impulsdauer $D_1$ der Impulsfolge $I_1$ und aus der dem 8-fachen Quantisierungsrest entsprechenden Dauer $D_{8R}$ ist:

$$D_2 = D_1 + D_{8R}$$

haben acht aufeinanderfolgende Impulse der Gesamtimpulsfolge $I_G$ die Gesamtdauer

$$7 \cdot D_1 + D_2 = 8 \cdot D_1 + D_{8R}$$

Dies entspricht einer mittleren Impulsdauer $D_M$:

$$D_M = (8 \cdot D_1 + D_{8R})/8 = D_1 + D_{8R}/8$$

Der von der Mittelungsschaltung 34 gebildete Gleichsignalmittelwert ist dieser mittleren Impulsdauer $D_M$ proportional.

Der Term $D_{8R}/8$ entspricht einem dem einfachen Quantisierungsrest proportionalen Anteil der Impulsdauer. Die mittlere Impulsdauer setzt sich also aus einem dem Quantisierungswert proportionalen Anteil und aus einem dem Quantisierungsrest proportionalen Anteil zusammen. Sie ist somit dem Wert der Eingangsgröße E mit einer der Berücksichtigung des Quantisierungsrestes entsprechenden höheren Genauigkeit proportional. Da bei dem gewählten Beispiel der Quantisierungsrest mit einer Auflösung von 3 Bit berücksichtigt wird, ergibt sich eine Erhöhung der Genauigkeit um den Faktor $2^3 = 8$. Diese erhöhte Genauigkeit bleibt in dem von der Mittelungsschaltung 34 gebildeten Gleichsignalmittelwert erhalten.

Die zuvor beschriebenen Maßnahmen zur Erhöhung der Genauigkeit bestehen also im allgemeinen Fall darin, daß für die Pulsdauermodulation der zweiten Impulsfolge die Summe aus dem für die Modulation der ersten Impulsfolge verwendeten Quantisierungswert und aus dem mit einem Faktor n multiplizierten Quantisierungsrest verwendet wird und daß die für die Mittelung verwendete Impulsfolge derart aus Impulsen der beiden Impulsfolgen zusammengesetzt ist, daß jeweils n aufeinanderfolgende Impulse einen Impuls der zweiten Impulsfolge und (n-1) Impulse der ersten Impulsfolge enthalten. Dann wird der im Impuls der zweiten Impulsfolge zusätzlich enthaltene n-fache Quantisierungsrest im Mittel auf n Impulsperioden aufgeteilt.

Insgesamt muß in der für die Mittelung verwendeten Gesamtimpulsfolge das Verhältnis der Anzahl der Impulse der zweiten Impulsfolge zur Gesamtzahl der Impulse dem Kehrwert des Faktors entsprechen, mit dem der Quantisierungsrest multipliziert wird.

Durch die beschriebenen Maßnahmen kann mit geringem zusätzlichen Schaltungsaufwand, der sich auf die Verwendung von 8 Bit-Schaltungen beschränkt, eine beträchtliche Erhöhung der Genauigkeit bei der Umwandlung einer Eingangsgröße in ein dazu proportionales Gleichsignal über die der 8 Bit-Auflösung entsprechende Genauigkeit hinaus erzielt werden. Die beschriebene Lösung erweist sich insbesondere deshalb als vorteilhaft, weil im Handel integrierte Schaltungen erhältlich sind, die zwei 8 Bit-Dauermodulatoren enthalten. Es ist daher möglich, den zweiten vorhandenen Pulsdauermodulator zur Erhöhung der Genauigkeit auszunutzen.

Natürlich ist die Erfindung nicht auf den Fall beschränkt, daß die Eingangsgröße als Analogsignal vorliegt, wie in der vorstehenden Beschreibung als Beispiel angenommen worden ist. Die Eingangsgröße kann durch ein beliebiges elektrisches Signal dargestellt sein, beispielsweise durch ein digitales Signal, eine Frequenz oder dergleichen. Wenn beispielsweise die Eingangsgröße durch eine parallele binäre Codegruppe dargestellt ist, kann der Analog-Digital-Umsetzer 20 von Fig. 2 durch ein Register ersetzt werden, in dem die Codegruppe gespeichert wird, oder die parallelen Übertragungsleitungen, über die die Codegruppe übertragen wird, können direkt mit den Eingängen der Register 22 und 36 verbunden werden. Die in jedem Fall erforderlichen Abänderungen der Schaltung sind dem Fachmann geläufig.

## Patentansprüche

1. Anordnung zur Umwandlung einer elektrischen Eingangsgröße (E) in ein dazu proportionales elektrisches Gleichsignal (A), mit einem ersten digitalen Pulsdauermodulator (24) begrenzter Auflösung, der eine erste periodische Impulsfolge ($I_1$) liefert, die mit dem der begrenzten Auflösung entsprechenden Quantisierungswert der Eingangsgröße unter Vernachlässigung des Quantisierungsrestes pulsdauermoduliert ist, einem zweiten Pulsdauermodulator (40) begrenzter Auflösung, der eine zweite periodische Impulsfolge ($I_2$) liefert, die in Abhängigkeit vom Quantisierungsrest pulsdauermoduliert ist, und mit einer Mittelungsschaltung (34) zur Bildung eines Gleichsignalmittelwerts aus den pulsdauermodulierten Impulsfolgen, dadurch gekennzeichnet, daß die von dem zweiten Pulsdauermodulator (40) gelieferte zweite periodische Impulsfolge mit der Summe aus dem der begrenzten Auflösung entsprechenden Quantisierungswert und dem mit einem vorbestimmten Faktor multiplizierten Quantisierungsrest pulsdauermoduliert ist, und daß eine Umschaltanordnung (28, 30, 42, 44) vorgesehen ist, die die Impulse der beiden Impulsfolgen derart abwechselnd zur Mittelungsschaltung (34) durchschaltet, daß das Verhältnis der Anzahl der durchgeschalteten Impulse der zweiten Impulsfolge ($I_2$) zur Gesamtzahl der durchgeschalteten Impulse gleich dem Kehrwert des vorbestimmten Faktors ist.

## Claims

1. An arrangement for the conversion of an electrical input quantity (E) into an electrical DC signal (A) proportional thereto, comprising a first digital pulse duration modulator (24) of limited resolution which supplies a first periodic pulse sequence ($I_1$) which is pulse duration modulated with the quantization value of the input quantity which corresponds to the limited resolution neglecting the quantization remainder, a second pulse duration modulator (40) of limited resolution which supplies a second periodic pulse sequence ($I_2$) which is pulse duration modulated dependent on the quantization remainder, and an averaging circuit (34) for forming a DC signal mean value of the pulse duration modulated pulse sequences, characterized in that the second periodic pulse sequence supplied by the second pulse duration modulator (40) is pulse duration modulated with the sum of the quantization value corresponding to the limited resolution and of the quantization remainder multiplied by a predetermined factor, and in that a switching arrangement (28, 30, 42, 44) is provided which selectively transmits the pulses of the two pulse sequences to the averaging circuit (34) in such a manner that the ratio of the number of transmitted pulses of the second periodic pulse sequence ($I_2$) to the total number of transmitted pulses is equal to the reciprocal of the predetermined factor.

**Revendications**

1. Dispositif destiné à la conversion d'une grandeur d'entrée électrique (E) en un signal d'égalité électrique (A) proportionnel, comprenant un premier modulateur numérique de durée des impulsions (24) de définition limitée, qui fournit une première série ($I_1$) d'impulsions périodique dont la durée est modulée avec la valeur de quantification de la grandeur d'entrée correspondant à la définition limitée sans tenir compte du reste de la quantification, un second modulateur de durée des impulsions (40) de définition limitée fournissant une seconde série ($I_2$) d'impulsions périodique dont la durée est modulée en fonction du reste de la quantification, et une prise médiane (34) destinée à former une valeur moyenne des séries d'impulsions de durée modulée, caractérisé en ce que la durée des impulsions de la seconde série d'impulsions périodique fournie par le second modulateur de durée d'impulsions (40) est modulée avec la somme de la valeur de quantification correspondant à la définition limitée et du reste de la quantification multiplié par un facteur prédéterminé, en ce qu'il est prévu un dispositif d'inversion (28, 30, 42, 44) qui connecte alternativement les impulsions des deux séries d'impulsions à la prise médiane (34) de telle sorte que le rapport entre le nombre d'impulsions raccordées de la seconde série d'impulsions ($I_2$) et le nombre total des impulsions raccordées correspond à la valeur inverse du facteur prédéterminé.

Fig.1

Fig.3

Fig. 2